# EUROPEAN PATENT SPECIFICATION

(11) **EP 1 566 426 B1**
(45) Date of publication and mention of the grant of the patent: **02.12.2015**
(21) Application number: 05101220.1
(22) Date of filing: 18.02.2005
(51) Int. Cl.: C09K 11/77, C09K 11/08

(54) **PHOSPHOR CONVERTED LIGHT EMITTING DEVICE**
LICHTEMITTIERENDE VORRICHTUNG, ENTHALTEND EINEN WELLENLÄNGENKONVERTIERENDEN LEUCHTSTOFF
DISPOSITIF ÉMETTANT DE LUMIÈRE CONVERTÉE PAR DES PHOSPHORES

(30) Priority: 23.02.2004 US 785620
(43) Date of publication of application: 24.08.2005
(73) Proprietor: Philips Lumileds Lighting Company LLC, San Jose CA 95131 (US)
(72) Inventor: Mueller-Mach, Regina, B., San Jose, CA 95131 (US); Mueller, Gerd, O., San Jose CA 95131 (US); juestel, Thomas, San Jose, CA 95131 (US); Busselt, Wolfgang, San Jose, CA 95131 (US); Schmidt, Peter, J., San Jose, CA 95131 (US); Mayr, Walter, San Jose, CA 95131 (US)
(74) Representative: Rüber, Bernhard Jakob

(56) References cited:
- WO-A1-01/24284
- WO-A2-2004/084261
- US-B1- 6 351 069
- WU J L ET AL: "SPECTRAL PROPERTIES OF VARIOUS CERIUM DOPED GARNET PHOSPHORS FOR APPLICATION IN WHITE GAN-BASED LEDS", MATERIALS RESEARCH SOCIETY SYMPOSIUM PROCEEDINGS; [MATERIALS RESEARCH SOCIETY SYMPOSIUM PROCEEDINGS], MATERIALS RESEARCH SOCIETY, USA, vol. 658, 1 January 2001 (2001-01-01), pages GG11.8.1-GG11.8.6, XP009036120, ISBN: 978-1-55899-828-5

## Description

### FIELD OF INVENTION

The present invention generally relates to an illumination system comprising a radiation source and a fluorescent material comprising a phosphor.

### DESCRIPTION OF RELATED ART

Recently, various attempts have been made to make white light emitting illumination systems by using light emitting diodes (LEDs) as radiation sources. When generating white light with an arrangement of red, green and blue light emitting diodes, there has been such a problem that white light of the desired tone cannot be generated due to variations in the tone, luminance and other factors of the light emitting diodes.

In order to solve these problems, there have been previously developed various illumination systems, which convert the color of light emitted by light emitting diodes, by means of a fluorescent material comprising a phosphor to provide a visible white light illumination.

Previous illumination systems have been based in particular either on the trichromatic (RGB) approach, i.e. on mixing three colors, namely red, green and blue, in which case the latter component may be provided by a phosphor or by the primary emission of the LED or in a second, simplified solution, on the dichromatic (BY) approach, mixing yellow and blue colors, in which case the yellow component may be provided by a yellow phosphor and the blue component may be provided by the primary emission of blue LED.

In particular, the dichromatic approach as disclosed in, for example, U.S. Patent 5,998,925 uses a blue light emitting diode of InGaN semiconductor combined with a Y₃Al₅O₁₂:Ce³⁺ (YAG-Ce³⁺) phosphor. The YAG-Ce³⁺ phosphor is coated on the InGaN LED, and a portion of the blue light emitted from the LED is converted to yellow light by the phosphor. Another portion of the blue light from the LED is transmitted through the phosphor. Thus, this system emits both blue light emitted from the LED, and yellow light emitted from the phosphor. The mixture of blue and yellow emission bands are perceived as white light by an observer with a CRI in the middle 80s and a color temperature, T_{c}, that ranges from about 6000 K to about 8000 K.

However, white light LEDs based on the dichromatic approach can only be used to a limited extent for general-purpose illumination, on account of their poor color rendering caused by the absence of red color components.

WO2004084261 describes an illumination system comprising a radiation source and a fluorescent material comprising at least one phosphor capable of absorbing a portion of the light emitted by the radiation source and emitting light of a wavelength different from that of the absorbed light; wherein said at least one phosphor is a green-emitting cerium-activated lutetium-aluminum-garnet of general formula (Lu_{1-x-y-a-b}YₓGd_{y})₃(Al_{1-z}Ga_{z})₅O₁₂:CeₐPr_{b} wherein 0 < x < 1, 0 < y < 1, 0 < z ≤ 0.1, 0 < a ≤ 0.2 and 0 < b ≤ 0.1. The invention also relates to with a green-emitting cerium-activated lutetiumaluminum-garnet of general formula (Lu_{1-x-y-a-b}YₓGd_{y})₃(Al_{1-z}Ga_{z})₅O₁₂:CeₐPr_{b} wherein 0 < x < 1, 0 < y < 1,0 < z ≤ 0.1, 0 < a ≤ 0.2 and 0 < b ≤ 0.1.

US6351069 describes a light emitting device and a method of fabricating the device utilize a supplementary fluorescent material that radiates secondary light in the red spectral region of the visible light spectrum to increase the red color component of the composite output light. The secondary light from the supplementary fluorescent material allows the device to produce "white" output light that is well-balanced with respect to color for true color rendering applications. The supplementary fluorescent material is included in a fluorescent layer that is positioned between a die and a lens of the device. The die is preferably a GaN based die that emits light having a peak wavelength of 470 nm. The fluorescent layer also includes a main fluorescent material. Preferably, the main fluorescent material is Cerium (Ce) activated and Gadolinium (Gd) doped Yttrium Aluminum Garnet (YAG) phosphor ("Ce:YAG phosphor"). In a first preferred embodiment, the supplementary fluorescent material is a compound that is produced by doping the Ce:YAG phosphor with a trivalent ion of Praseodymium (Pr). In a second preferred embodiment, the supplementary fluorescent material is Europium (Eu) activated Strontium Sulphide (SrS) phosphor. The amount of supplementary phosphor in the fluorescent layer can vary depending on the amount of red color that may be required in the white output light. The exact amount of supplementary phosphor is not critical to the invention.

WO0124284 describes an LED device that performs phosphor conversion on substantially all of the primary light emitted by the light emitting structure of the LED device to produce white light. The LED device comprises at least one phosphor-converting element located to receive and absorb substantially all of the primary light emitted by the light-emitting structure. The phosphor-converting element emits secondary light at second and third wavelengths that combine to produce white light. The second wavelength is greater than the first wavelength and the third wavelength is greater than the second wavelength. The phosphor-converting element generates the secondary light at the third wavelength in response to excitation by the primary light and/or the secondary light at the second wavelength. The excitation by the secondary light at the second wavelength is effected by macroscopic absorption and/or quantum-mechanical transfer. The phosphor-converting element includes either (a) a first host material doped with a first dopant and a second host material doped with a second dopant, or (b) a host material doped with a first dopant and a second dopant. The first dopant emits the secondary light at the second wavelength and the second dopant emits the secondary light at the third wavelength. Additional host materials may be included in the phosphor-converting element, or additional phosphor-converting elements may be included in the LED device, that produce additional wavelengths of secondary light that combine with the second and third wavelengths of secondary light to produce white light.

Wu et al, Mat. Res. Soc. Symp. Proc. Vol. 658 (2001), materials Research Society, GG118.1-GG11.8.6 describes spectral properties of various cerium doped garnet phosphors for application in white GaN-based LEDs.

### SUMMARY

In accordance with embodiments of the invention, a system includes a radiation source capable of emitting first light and a fluorescent material capable of absorbing the first light and emitting second light having a different wavelength than the first light. The fluorescent material is a phosphor having the formula (Lu_{1-x-y-a-b}YₓGd_{y})₃(Al_{1-z}Ga_{z})₅O₁₂:CeₐPr_{b} wherein 0 < x < 1, 0 < y < 1, 0 < z ≤ 0.1, 0 < a ≤ 0.2 and 0 < b ≤ 0.1. (Lu_{1-x-y-a-b}YₓGd_{y})₃(Al_{1-z}Ga_{z})₅O₁₂:CeₐPr_{b} is combined with a second fluorescent material capable of emitting third light. The second fluorescent material may be a red-emitting phosphor, such that the combination of first, second, and third light emitted from the system appears white.

### BRIEF DESCRIPTION OF THE DRAWINGS

Fig. 1 shows a schematic view of a tri-color white LED lamp comprising a two- phosphor blend positioned in a pathway of light emitted by an LED structure.
Fig. 2A (reference example) shows the coordinates of phosphor mixtures of (Lu_{0.495}Y_{0.495}Ce_{0.01})₃Al₅O₁₂ and CaS in the chromaticity diagram of the Commission Internationals de I'Eclairage ("CIE"). Fig. 2B (reference example) shows the coordinates of phosphor mixtures of Lu₃Al₅O₁₂:Ce³⁺ and Sr₂Si₅N₈:Eu in the CIE diagram. Blends of these phosphors may be produced to have coordinates close to the black body locus.
Fig. 3 illustrates emission spectra of green LEDs upon excitation by a blue LED at 460 nm.
Figs. 4A and 4B illustrates emission spectra of white LEDs.
Fig. 5 (reference example) illustrates the excitation and emission spectra of (Lu_{0.99}Ce_{0.01})₃Al₅O₁₂.
Fig. 6 (reference example) illustrates the excitation and emission spectra of (Lu_{0.989}Ce_{0.01}Pr_{0.001})₃Al₅O₁₂.
Fig. 7 (reference example) illustrates the excitation and emission spectra of (Lu_{0.495}Y_{0.495}Ce_{0.01})₃Al₅O₁₂.
Fig. 8 (reference example) illustrates the relative intensity of Lu₃Al₅O₁₂:Ce³⁺ as a function of temperature.
Fig. 9 illustrates the relative intensity of Sr₂Si₅N₈:Eu²⁺ as a function of temperature.
Fig. 10 (reference example) illustrates excitation and emission spectra of Lu₃Al₅O₁₂:Ce³⁺ and Y₃Al₅O₁₂:Ce³⁺.
Figs. 11, 12, 13, and 14 illustrate embodiments of the invention including multiple phosphors.

### DETAILED DESCRIPTION

Embodiments of the invention provide new phosphors that are excitable in the near UV-to-blue range and emit in the visible green range. The new phosphors are capable of absorbing a part of light emitted by a radiation source and emitting light of a wavelength different from the absorbed light.

Embodiments of the present invention focus on a lutetium aluminum garnet as a phosphor in any configuration of an illumination system containing a radiation source, including, but not limited to discharge lamps, fluorescent lamps, LEDs, laser diodes and X-ray tubes. In some embodiments, the lutetium aluminum garnet phosphor is cerium-activated. As used herein, the term "radiation" encompasses radiation in the UV, IR and visible regions of the electromagnetic spectrum.

While the use of the present phosphor is contemplated for a wide array of illumination, the present invention is described with particular reference to and finds particular application to light emitting diodes, especially UV- and blue-light-emitting diodes.

The fluorescent material according to embodiments of the invention comprises as a phosphor a cerium-activated lutetium-aluminum-garnet compound. The phosphor conforms to the general formula (Lu_{1-x-y-a-b}YₓGd_{y})₃(Al_{1-z}Ga_{z})₅O₁₂:CeₐPr_{b} wherein 0 < x < 1, 0 < y < 1,0 < z ≤ 0.1, 0 < a ≤ 0.2 and 0 < b ≤ 0.1.

This class of phosphor material is based on activated luminescence of cubic garnet crystals. Garnets are a class of materials with the crystal chemical formula A₃B₅O₁₂.

A garnet crystal lattice has three different atomic occupying sites of dodecahedron octacoordination, octahedron hexacoordination and tetrahedron tetracoordination, in which the A cations are eight-coordinated with oxygens and the B cations are either octahedrally (six) or tetrahedrally (four) coordinated with oxygens. The crystal structure is cubic with 160 ions per unit cell containing eight formula units. In embodiments of the present invention, the A cations are lutetium ions alone or in combination with Yttrium and Gadolinium, in combinations and with activator substitutions of cerium and possibly praseodymium. The B cations may be aluminum and may be gallium or other ions, again, alone, in combinations and/or with substitutions. In particular, it was found that with activator ions substituted in the eight-coordinated or six-coordinated sites, these garnets are luminescent in response to x-ray stimulation. A particularly important activator ion, which is x-ray luminescent in this host material, is the Ce³⁺ ion located in eight-coordinated sites.

Replacing some of the lutetium in a cerium activated lutetium aluminum garnet, Lu₃Al₅O₁₂:Ce phosphor with a smaller ion such as gadolinium Gd³⁺ or yttrium Y³⁺ causes a shift in the phosphor's emission band from green to the yellow range.

Replacing some of the aluminum in a cerium activated lutetium aluminum garnet, Lu₃Al₅O₁₂:Ce phosphor with a larger ion such as gallium Ga³⁺ causes a shift in the phosphor's emission band from green to the blue range.

Replacing some of the cerium in a cerium-activated lutetium-aluminum-garnet by praseodymium as a co-activator has the effect that the praseodymium produces secondary emission that is concentrated in the red region of the visible spectrum, instead of a typical broadband secondary emission from cerium-activated lutetium-aluminum-phosphor that is generally centered in the yellow region of the visible spectrum. The amount of praseodymium as a co-activator can vary, depending on the amount of red color that may be required in the white output light for a particular application. Compositions having praseodymium as an activator cation present at low concentrations may be particularly desirable since such compositions show a sharp line emission in the red region of the visible spectrum.

The lutetium concentration influences the color locus of the emission light when used in a light source, in particular an LED. The color locus of this phosphor can be additionally fine-tuned using the ratio of the two concentrations Lu:Ce, which simplifies or optimizes adaptation to any further (yellow or red) phosphors in the LED. As the concentration of Ce in the phosphor increases, the blue-end of the emission spectrum of the phosphor shifts to longer wavelengths. In some embodiments, the phosphor contains about 1 to about 1.5 mole-percent Ce.

Preferably these garnet phosphors may be coated with a thin, uniform layer of one or more compounds selected from the group formed by the fluorides and orthophosphates of the elements aluminum, scandium, yttrium, lanthanum gadolinium and lutetium, the oxides of aluminum, yttrium and lanthanum and the nitride of aluminum.

The layer thickness customarily ranges from 0.001 to 0.2 µm and, thus, is so thin that it can be penetrated by the radiation of the radiation source without substantial loss of energy. The coatings of these materials on the phosphor particles can be applied, for example, by deposition from the gas phase or a wet-coating process.

The phosphors according to the invention are responsive to ultraviolet light as in fluorescent lamps and light emitting diodes, visible light as in blue-emitting diodes, electrons (as in cathode ray tubes) and x-rays (as in radiography).

The invention also concerns an illumination system comprising a radiation source and a fluorescent material comprising at least one phosphor of general formula (Lu_{1-x-y-a-b}YₓGd_{y})₃(Al_{1-z}Ga_{z})₅O₁₂:CeₐPr_{b} wherein 0 < x < 1, 0 < y < 1, 0 <z ≤ 0.1, 0 < a ≤ 0.2 and 0 < b ≤ 0.1.

Radiation sources include semiconductor optical radiation emitters and other devices that emit optical radiation in response to electrical excitation. Semiconductor optical radiation emitters include light emitting diode LED chips, light emitting polymers (LEPs), organic light emitting devices (OLEDs), polymer light emitting devices (PLEDs), etc.

Moreover, light emitting components such as those found in discharge lamps and fluorescent lamps, such as mercury low and high pressure discharge lamps, sulfur discharge lamps, and discharge lamps based an molecular radiators are also contemplated for use as radiation sources with the present inventive phosphor compositions.

In a preferred embodiment of the invention the radiation source is a light-emitting diode. Any configuration of an illumination system which includes a LED and a cerium- activated lutetium-aluminum garnet phosphor composition is contemplated in the present invention, preferably with addition of other well-known phosphors, which can be combined to achieve a specific color or white light of high efficiency and/or high color rendering index ("CRI") at a required color temperature, when irradiated by a LED emitting primary UV or blue light as specified above. White-emitting devices according to embodiments of the present invention are based on the combination of blue, red, and green colors. In some embodiments, the yellow to green and the red phosphors are so broad-banded that they have a sufficient proportion of emission throughout the whole spectral region.

In a preferred embodiment of the invention the primary radiation source used is the radiation from a UV-emitting or blue-emitting LED-chip. Particularly good results are achieved with a blue LED whose emission maximum lies at 400 to 480 nm. Optimal ranges have been found to lie at 445 to 460 nm and 438 to 456 nm, taking particular account of the excitation spectrum of the garnet phosphors described above.

Desirable white light lamp characteristics for general purposes are high brightness and high color rendering at economical cost. Improved efficiency and much improved color rendering ability is possible with the trichromatic lamp spectrum according to the RGB-approach having three emission bands: red at 590 to 630, green at 520 to 560 and blue at 450 nm. These wavelengths are near peaks in the CIE tristimulus functions, which are used to define colors.

In some embodiments, particularly good color rendering is achieved by the joint use of two phosphors, namely a green emitting cerium-activated lutetium-aluminum-garnet phosphor of general formula (Lu_{1-x-y-a-b}YₓGd_{y})₃(Al_{1-z}Ga_{z})₅O₁₂:CeₐPr_{b} wherein 0 < x < 1, 0 < y < 1, 0 < z ≤ 0.1, 0 < a ≤ 0.2 and 0 < b ≤ 0.1 together with a second phosphor. The second phosphor may be, for example, a red-emitting phosphor, such as a red emitting europium-activated phosphor selected from the group of (Ca₁₋ₓSrₓ)S:Eu wherein 0 < x ≤ 1 and (Sr_{1-x-y}BaₓCa_{y})_{2-z}Si₅₋ₐAlₐN₈₋ₐOₐ:Eu_{z} wherein 0 ≤ a < 5, 0 < x ≤ 1, 0 ≤ y ≤ 1, and 0 z ≤ 1.

Preferably a europium activated calcium strontium sulfide is used, which is a high chromaticity red phosphor excitable from the near UV (400 nm) to the blue-green (500 nm) with high quantum efficiency. For an optimized use of this phosphor for luminescent conversion of primary LED light it is necessary to modify the photophysical characteristics to achieve, for example, efficacy, color specifications and life time of related light emitting devices. The chromaticity and quantum efficiency of the europium activated strontium sulfide can be modified through the substitution of divalent metal ions for strontium from the list including Ba, Ca, Mg, and Zn. Suitable red phosphors are described in the following

**table:**

| Phosphor composition | λₘₐₓ [nm] | Color point x, y |
|---|---|---|
| SrS:Eu | 610 | 0.627, 0.372 |
| (Sr_{1-x-y}BaₓCa_{y})₂Si₅N₈:Eu | 615 | 0.615,0.384 |
| (Sr_{1-x-y}BaₓCa_{y})₂Si₅₋ₓAlₓN₈₋ₓOₓ:Eu | 615-650 | Depends on x, y |
| CaS:Eu | 655 | 0.700, 0.303 |
| (Sr₁₋ₓCaₓ)S:Eu | 610-655 | Depends on x, y |

The phosphor blend comprises a mixture of predetermined amounts and relative proportions of garnet-structured lutetium-aluminum oxide activated by cerium and calcium-strontium sulfide activated by divalent europium. The relative phosphor proportions are such that the composite emission of the first phosphor layer falls approximately within the warm-white ellipse as inscribed on the x-y chromaticity diagram of the ICI system.

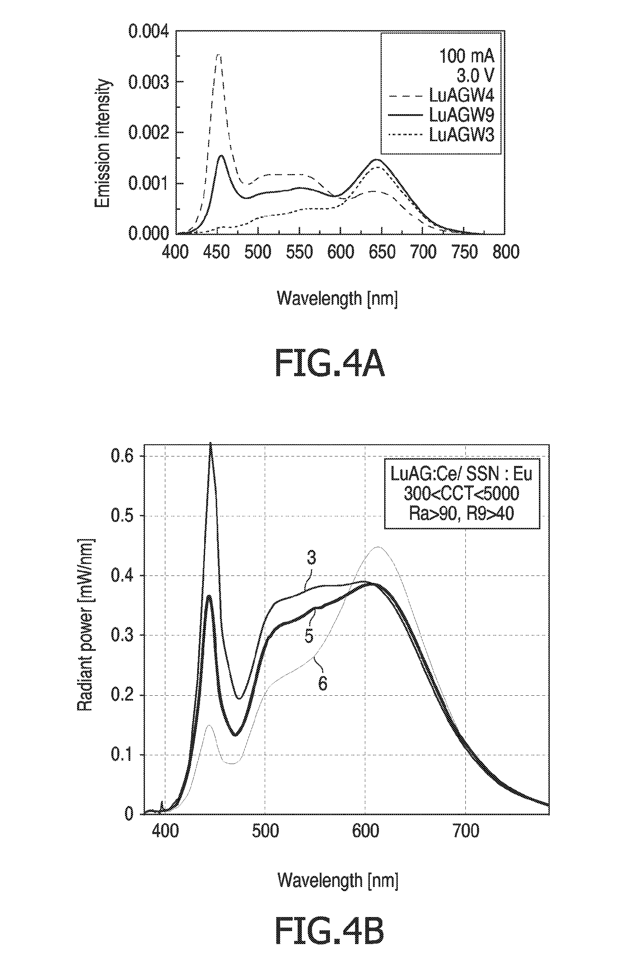

A white emitting radiation source comprising a InGaN chip, emitting in the blue range of the visible spectrum with a peak emission at 455 nm together with a phosphor blend comprising Lu₃Al₅O₁₂:Ce and CaS:Eu with the corresponding spectral weight ratio blue:green:red = 1.1:2.4:2.18 emits white light with color coordinates x = 0.336 and y = 0.339 and index of color rendering of 83. The spectra of such white emitting devices comprising three different blends of Lu₃Al₅O₁₂:Ce and CaS:Eu are given in Fig. 4A.

Fig. 4B illustrates spectra of three white devices including blends of Lu₃Al₅O₁₂:Ce and Sr₂Si₅N₈:Eu, excited by a blue LED at 450 nm.

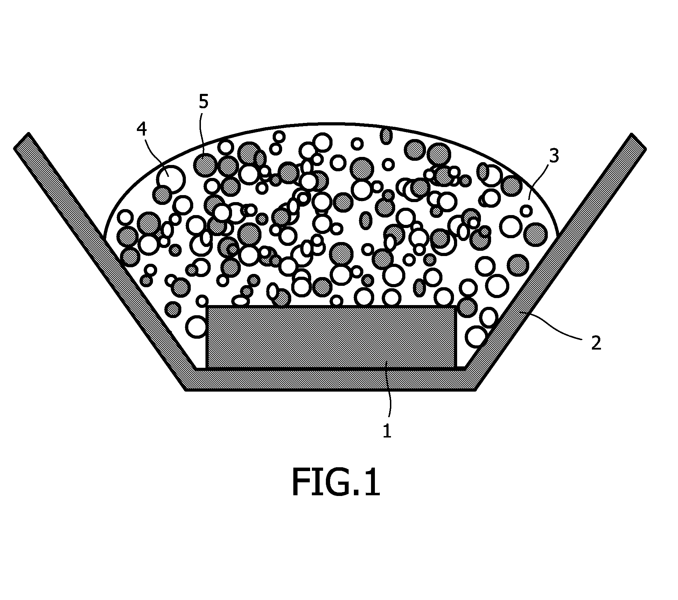

A detailed construction of such a light-emitting device is shown in Fig. 1. The device of Fig. 1 comprises an LED 1 positioned in a reflector cup 2. A phosphor composition 4,5 is positioned in the path of light emitted by LED 1. The phosphor composition is embedded in a resin. The shape of reflector cup 2 may be selected to provide a particular pattern of light emitted from the device, as is known in the art. For example, the walls of reflector cup 2 can be parabolic.

In one embodiment, the device further comprises a polymer for encapsulating the phosphor or phosphor blend. In this embodiment, the phosphor or phosphor blend should exhibit high stability properties in the encapsulant. Preferably, the polymer is optically clear to prevent significant light scattering. In one embodiment, the polymer is selected from the group consisting of epoxy and silicone resins. A variety of polymers are known in the LED industry for making LED lamps. Adding the phosphor mixture to a liquid that is a polymer precursor can perform encapsulation. For example, the phosphor mixture can be a powder. Introducing phosphor particles into polymer precursor liquid results in formation of a slurry (i.e. a suspension of particles). Upon polymerization, the phosphor mixture is fixed rigidly in place by the encapsulation. In one embodiment, both the composition and the LED are encapsulated in the polymer.

The phosphors are applied either separately or in a mixture. The phosphors completely or partially absorb the light from the LED and emit it again in other spectral regions (primarily yellow and green) in a sufficiently broad band (specifically with a significant proportion of red) that an overall emission with the desired color point is formed. The wavelength of the LED is tuned to the particular phosphors in the blend such that each of the phosphors in the blend is excited by emission from the LED. A phosphor blend using wide band phosphors according to embodiments of the invention may have a relatively high color rendering index, as high as 91-93. In the case of an LED emitting UV light, for example between about 330 nm and about 365 nm, in order to achieve high color rendering, in addition to yellow/green and red phosphors described above, the phosphor blend may also include a phosphor that emits blue light.

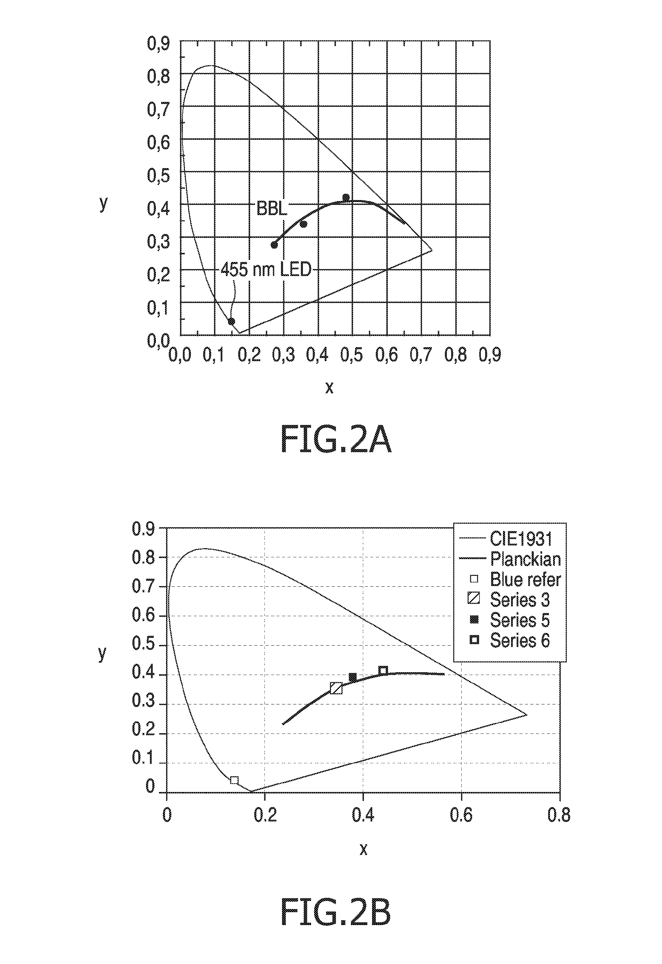

The color points corresponding to a black body at various temperatures are given by the black body locus (BBL). Because the color emitted from a black body is considered to be white, and white light is generally desirable for a lamp, it is generally desirable that color point of the light emitted from the luminescent material of a luminescent lamp fall on or near the BBL. A portion of the BBL shown in Fig. 2A includes three color temperature points highlighted on the BBL corresponding to white light emitting LEDs, whose emission spectra are given in Fig. 4A. A portion of the BBL shown in Fig. 2B includes three color temperature points highlighted on the BBL corresponding to white light emitting LEDs, whose emission spectra are given in Fig. 4B.

Another figure of merit is the quality in rendering illuminated colors of a white light emitting radiation source, which is indicated as the color rendering index (CRI). A CRI of 100 is an indication that the light emitted from the light source is similar to that from a black body source, i.e. an incandescent or halogen lamp. A CRI of 85 to 95 can be attained by applying a phosphor mixture comprising Lu₃Al₅O₁₂:Ce and CaS:Eu to a blue-emitting LED.

Figs. 2A and 2B show the color coordinates of a range of illumination systems providing white light that can be produced from various combinations of blue LEDs and a cerium-activated lutetium-aluminum-garnet phosphor and CaS:Eu or Sr₂Si₅N₈:Eu of the present invention.

More than one phosphor according to embodiments of the present invention may be incorporated in the same device to provide for color adjustment.

A green emitting illumination system with particularly good color rendering comprises the combination of a light emitting semiconductor component which emits primary light in the blue spectral range from 420 to 480 nm together with a phosphor blend containing a green emitting cerium-activated lutetium-aluminum garnet phosphor Lu₃Al₅O₁₂:Ce, with the corresponding spectral weight ratio blue:green is chosen from 1.0:2.4 to 1.0:3.5 which emits green light with color coordinates x = 0.336 and y = 0.339, an index of color rendering of 83, and a lumen equivalent of about 450 lumen/Watt.

The green-emitting phosphor may be combined when appropriate, with a further yellow or red-emitting phosphor for the production of specific colored light and more preferably for production of white light with a high color-rendering index of greater than 80.

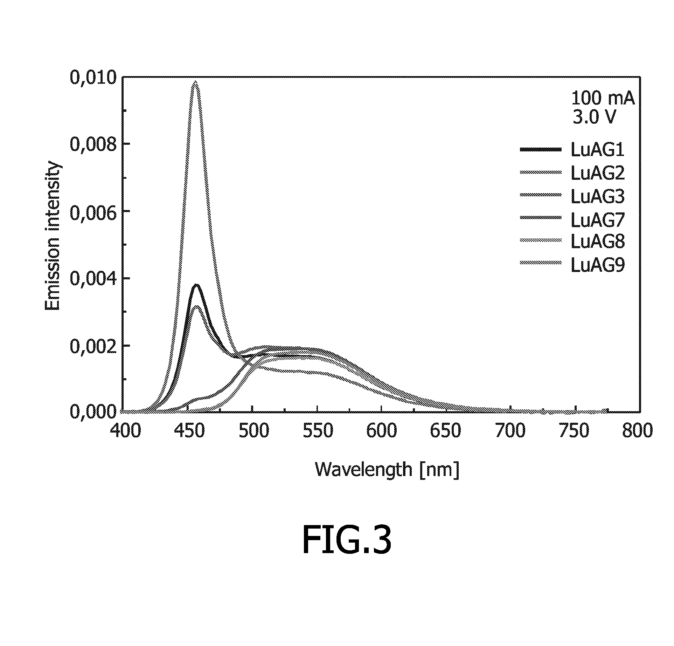

As a result of the green to yellow broad-band emission, a green emission can be generated which is shown in some examples in Fig. 3. As the amount of phosphor disposed on the device increases, eventually all of the emission from the LED is absorbed, such that only emission from the phosphor remains. Devices with such heavy phosphor loading may be used in applications requiring green light.

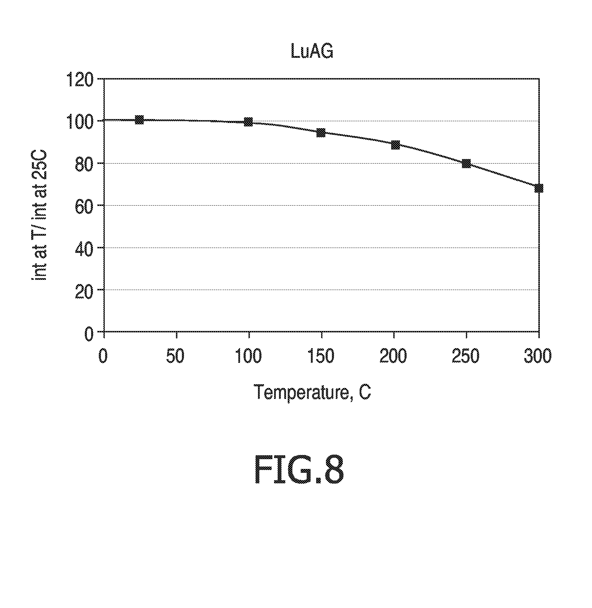

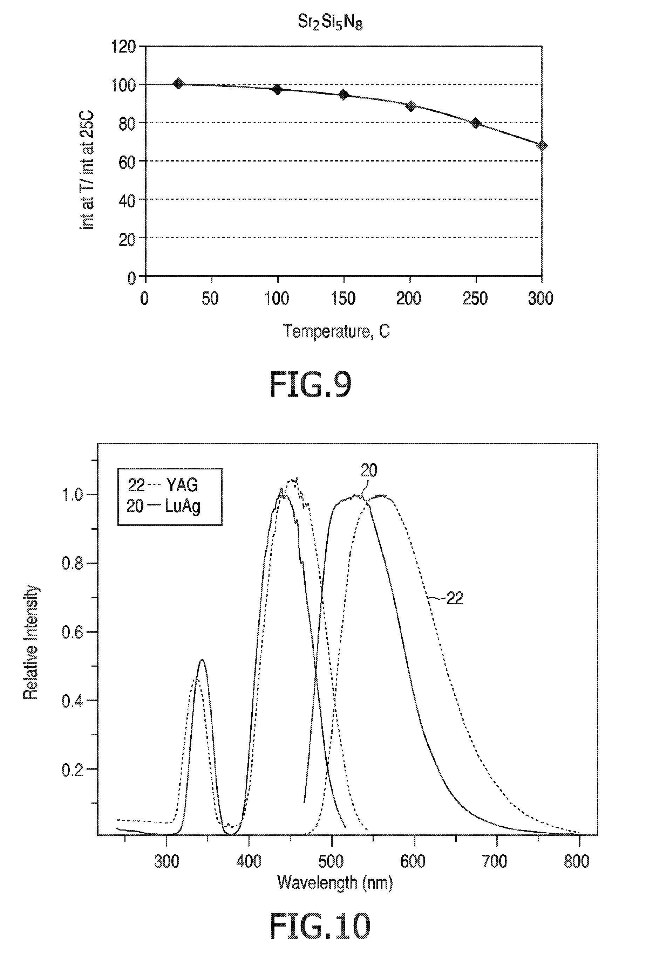

The garnet phosphors described above emit a broad band in the yellow-green spectral range of the visible spectrum with very high intensity under both UV and blue excitations and thus can provide the green component in LEDs emitting specific colors or white light. Total conversion efficiency can be up to 90%. Additional important characteristics of the phosphors include 1) resistance to thermal quenching of luminescence at typical device operating temperatures (e.g. 80°C); 2) lack of interfering reactivity with the encapsulating resins used in the device fabrication; 3) suitable absorptive profiles to minimize dead absorption within the visible spectrum; 4) a temporally stable luminous output over the operating lifetime of the device and; 5) compositionally controlled tuning of the phosphors excitation and emission properties. Fig. 8 illustrates the relative intensity of Lu₃Al₅O₁₂:Ce³⁺ as a function of temperature. The relative intensity is expressed as a percentage of the intensity at room temperature, 25°C. At 200°C, the Lu₃Al₅O₁₂:Ce³⁺ emission intensity is 90% of room temperature intensity. At 300°C, the Lu₃Al₅O₁₂:Ce³⁺ emission intensity is 70% of room temperature intensity. In embodiments requiring white light and operation at high temperature, Sr₂Si₅N₈:Eu²⁺ is preferred as a red phosphor as it exhibits similar performance at high temperatures, as illustrated in Fig. 9, which illustrates the relative intensity of Sr₂Si₅N₈:Eu²⁺ as a function of temperature. At 200°C, the Sr₂Si₅N₈:Eu²⁺ emission intensity is 90% room temperature intensity.

Lutetium-containing garnet phosphors included with other phosphors in devices designed to emit white light may offer improved color rendering over garnet phosphors that do not include lutetium, such as Y₃Al₅O₁₂:Ce³⁺. The improved color rendering is due to the smaller Stokes' shift of Lu₃Al₅O₁₂:Ce³⁺ relative to Y₃Al₅O₁₂:Ce³⁺. Phosphors such as Lu₃Al₅O₁₂:Ce³⁺ and Y₃Al₅O₁₂:Ce³⁺ absorb an excitation energy typically in the form of radiation, store the energy, then emit the stored energy as radiation of a different energy. When the emitted radiation has less quantum energy than the absorbed radiation, the wavelength of the emitted light increases over the absorbed light. This increase is referred to as the Stokes' shift. Fig. 10 illustrates the smaller Stokes' shift of Lu₃Al₅O₁₂:Ce³⁺ as demonstrated by excitation and emission spectra of Lu₃Al₅O₁₂:Ce³⁺ and Y₃Al₅O₁₂:Ce³⁺. Though the excitation spectra of both phosphors are very similar, the peak emission from Lu₃Al₅O₁₂:Ce³⁺ (curve 20) occurs at a wavelength about 40 nm shorter than the peak emission from Y₃Al₅O₁₂:Ce³⁺ (curve 22). When used in a white device, the smaller Stokes' shift of Lu₃Al₅O₁₂:Ce³⁺ eliminates a gap in the spectrum of combined pump emission and phosphor emission at long blue wavelengths and short green wavelengths, resulting in better color rendering.

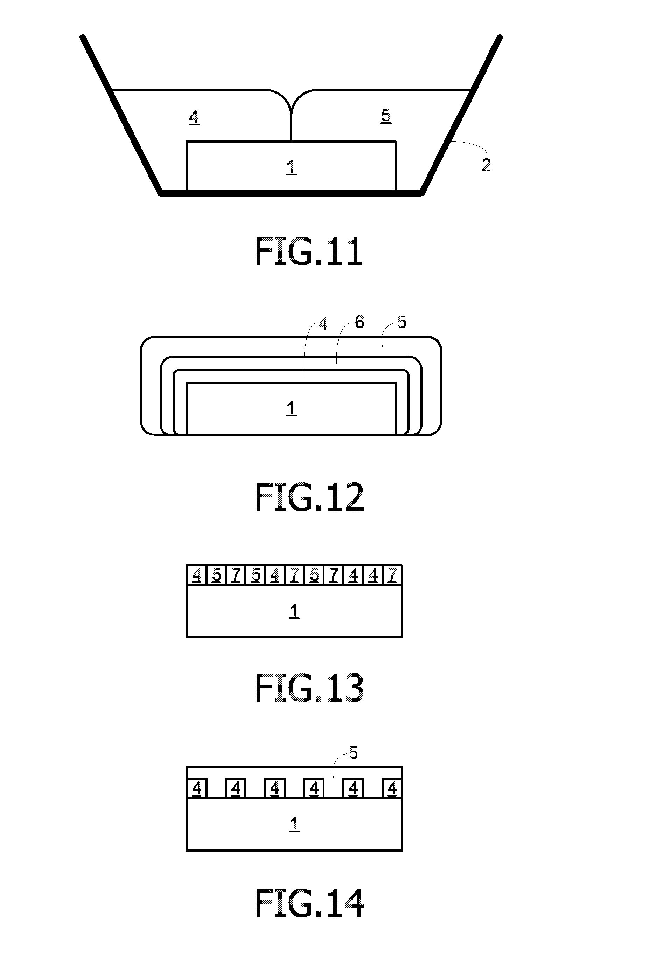

In a device where a red-emitting phosphor is mixed with a lutetium-containing garnet phosphor, such as the device illustrated in Fig. 1, it may be difficult to exploit the small Stokes' shift of the lutetium-containing garnet phosphor since the red-emitting phosphor may absorb a significant portion of the light emitted by the lutetium-containing garnet phosphor. Lutetium-containing garnet phosphors tend to be very dense. As a result, when a slurry containing such phosphors is deposited over a device, the lutetium-containing garnet phosphor particles tend to sink quickly, leaving most of the lutetium-containing garnet phosphor close to the device and most of the red-emitting phosphor further from the device. Light emitted by the lutetium-containing garnet phosphor thus has a high likelihood of striking a red-emitting phosphor particle and being absorbed. Figs. 11-14 illustrate embodiments of the device where the red-emitting phosphor and lutetium-containing garnet phosphor are deposited such that absorption by the red-emitting phosphor of light emitted by the lutetium-containing garnet phosphor is minimized.

In the device illustrated in Fig. 11, the lutetium-containing garnet phosphor 5 is mixed with a resin or other transparent material and disposed on one side of reflector cup 2, while any other phosphors 4 are mixed separately with a resin or other transparent material and disposed on the other side of reflector cup 2, such that slurry 5 does not appreciably mix with slurry 4. In some embodiments, the viscosity of the transparent material forming the slurry is selected to avoid mixing phosphor 4 with phosphor 5. Since lutetium-containing garnet phosphor 5 and any other phosphors 4 are adjacent to each other, rather than mixed in the same slurry, light emitted by lutetium-containing garnet phosphor 5 is less likely to be absorbed by any red-emitting phosphors in slurry 4.

In the device illustrated in Fig. 12, the lutetium-containing garnet phosphor 5 and other phosphors 4 are deposited over LED 1 as discrete layers. Phosphor layer 4, including any red-emitting phosphors, is deposited closest to LED 1. Lutetium-containing garnet phosphor 5 is then deposited over phosphor layer 4. Phosphor layers 4 and 5 may be separated by an optional transparent layer 6. Phosphor layers 4 and 5 may be deposited as slurries in a resin or other transparent material; deposited as thin films by, for example, electron beam evaporation, thermal evaporation, rf-sputtering, chemical vapor deposition, or atomic layer epitaxy; or deposited as conformal layers over LED 1 by, for example, screen printing, stenciling as described in U.S. Patent 6,650,044, or by electrophoretic deposition as described in U.S. Patent 6,576,488. Thin films are described in more detail in U.S. Patent 6,696,703. Each of U.S. Patent 6,696,703, U.S. Patent 6,650,044 and U.S. Patent 6,576,488 are incorporated herein by reference. In contrast to a thin film, which typically behaves as a single, large phosphor particle, the phosphor in a conformal layer generally behaves as multiple phosphor particles. In addition a thin film typically contains no materials other than phosphor. A conformal layer often includes materials other than phosphor, such as, for example, silica.

In the device illustrated in Fig. 13, the lutetium-containing garnet phosphor 5 and other phosphors 4 are deposited on LED 1 in a plurality of small regions. The different regions may form a pattern, such as a checkerboard pattern. If light from LED 1 is to escape unconverted, as in the case where blue light emitted by the LED mixes with green and red light emitted by phosphors to make white light, the amount of unconverted light may be controlled by controlling the thickness of phosphor regions 4 and 5, or by leaving regions of LED 1 uncovered, or covered by an optional transparent material 7 that does not convert the light emitted by LED 1. Patterns of different phosphor layers as illustrated in Fig. 13 may be formed by depositing a first layer of phosphor by electrophoretic deposition, patterning that layer using conventional lithography and etching techniques, then depositing a second phosphor layer by electrophoretic deposition. Alternatively, patterns of phosphor layers may be deposited by screen printing or ink jet printing. In some embodiments, a pattern of phosphor layers may be formed by pipetting the individual phosphor mixes 4 and 5 into wells in a clear plastic microplate used for microbiology. The phosphor-filled microplate is then placed on LED 1. Phosphor-filled microplates may be formed separately from LED 1.

In the device illustrated in Fig. 14, a plurality of small regions of phosphor 4, which includes any red-emitting phosphors, is formed on the surface of LED 1. A layer of lutetium-containing garnet phosphor 5 is then deposited over the plurality of regions of phosphor 4.

Each of the embodiments illustrated in Figs. 11-14 avoid the problem of light being absorbed and reemitted by the lutetium-containing garnet phosphor prior to being incident on a red-emitting phosphor. In each case, light emitted by LED 1 is incident on the red-emitting phosphor first, or is incident on the red-emitting phosphor and the lutetium-containing garnet phosphor in separate regions. The arrangements illustrated in Figs. 11-14 thus reduce the probability of light emitted from the lutetium-containing garnet phosphor being absorbed by a red-emitting phosphor.

Lutetium-containing garnet phosphors according to the present invention are easily synthesized, as illustrated in the following example:

### EXAMPLE

For the phosphor synthesis of a phosphor of general formula (Lu_{1-x-y-a-b}YₓGd_{y})₃(Ai_{1-z}Ga_{z})₅O₁₂:CeₐPr_{b} wherein 0 < x < 1, 0 < y < 1, 0 <z ≤ 0.1, 0 < a ≤ 0.2 and 0 < b ≤ 0.1, one or more of the starting materials may be oxygen-containing compounds such as oxides, nitrates, sulfates, acetates, citrates, or chlorates, which are soluble in a nitric acid solution. For example, amounts of Lu₂O₃, Al(NO₃)₃·9H₂O, Ce(NO₃)₃·6H₂O and AlF₃ are blended and dissolved in a nitric acid solution. The strength of the acid solution is chosen to rapidly dissolve the oxygen-containing compounds and the choice is within the skill of a person skilled in the art. The nitric acid solution is evaporated. The dried precipitate is ball milled or otherwise thoroughly blended and then calcined in a CO-atmosphere at about 1300°C for a sufficient time to ensure a substantially complete dehydration of the starting material. The calcination may be carried out at a constant temperature. Alternatively, the calcinations temperature may be ramped from ambient to and held at the final temperature for the duration of the calcination. After an intermittent milling step the calcined material is similarly fired at 1500-1700°C under a reducing atmosphere such as H₂, CO, or a mixture of one of these gases with an inert gas. The calcined material is fired for a sufficient time for the decomposition of the oxygen-containing compounds to convert all of the calcined material to the desired phosphor composition.

The resulting powder is milled on a roller bench for several hours. The milled powder has an average particle size of 40 to 60 µm. Its quantum efficiency is 90 % and its lumen equivalent is between 430 and 470 1m/W. The color point is at x = 0.33 to 0.38, y = 0.57 to 0.58. The table below gives the wavelength and color point of several suitable phosphor compounds.

| Phosphor composition | λₘₐₓ [nm] | Color point x, y |
|---|---|---|
| (Lu_{0.99}Ce_{0.01})₃Al₅O₁₂ | 515 + 540 | 0.339, 0.579 |
| (Lu_{0.989}Ce_{0.010}Pr_{.001})₃Al₅O₁₂ | 515 + 540 + 610 | 0.332, 0.574 |
| (Lu_{0.495}Y_{0.495}Ce_{0.01})₃Al₅O₁₂ | 525 + 550 | 0.377, 0.570 |
| (Lu_{0.75}Gd_{0.24}Ce_{0.01})₃Al₅O₁₂ | 520 + 545 | 0.350, 0.573 |

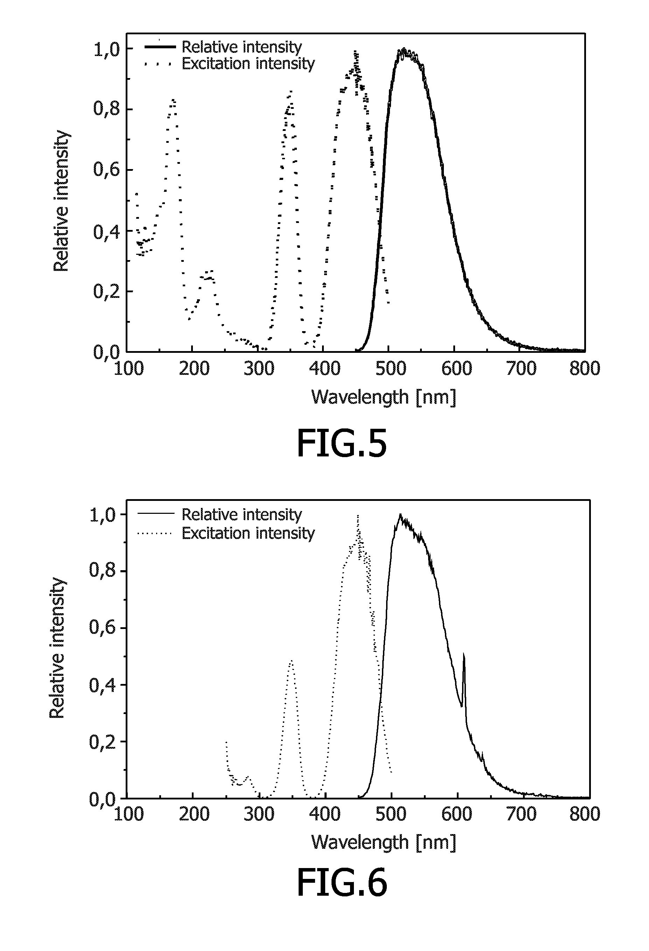

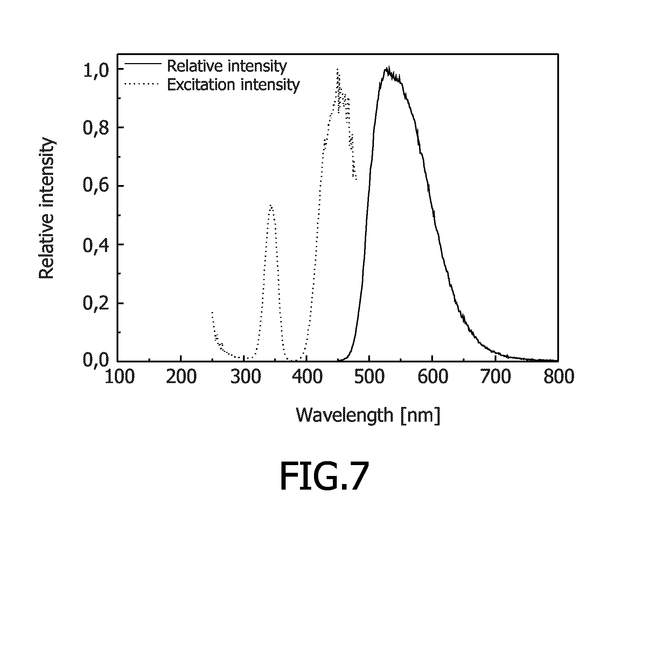

Figs. 5, 6, and 7 illustrate the emission spectra of some of the compounds in the above table. When excited with radiation of wavelength 355 nm, these garnet phosphors are found to give a broad band emission, which peaks at 515 nm. Fig. 5 shows excitation and emission spectra for the composition (Lu_{o.99}Ce_{0.01})₃Al₅O₁₂. Fig. 6 shows excitation and emission spectra for the composition (Lu_{0.495}Y_{0.494}Ce_{0.01})₃Al₅O₁₂. Fig, 7 demonstrates that the excitation band of (Lu_{0.989}Ce_{0.010}Pr_{.001})₃Al₅O₁₂, is a broad band (515 - 540 nm) with a peak extending from 515 - 540 nm and a side band at 610 nm.

From the excitation spectra, it is also clear that these cerium-activated lutetium-aluminum garnet phosphors can be excited efficiently with radiation of wavelength 254 as well as 355 and 420 nm.

For manufacturing a white illumination system based on a 460 nm emitting InGaN LED, a phosphor blend comprising at least one of the suitable red phosphors as claimed is suspended into a silicone precursor. A droplet of this suspension is deposited onto the LED chip and subsequently polymerized. A plastic lens seals the LED.

Having described the invention in detail, those skilled in the art will appreciate that, given the present disclosure, modifications may be made to the invention without departing from the spirit of the inventive concept described herein. Therefore, it is not intended that the scope of the invention be limited to the specific embodiments illustrated and described.

## Claims

1. A system comprising:
a radiation source capable of emitting first light;
a first fluorescent material capable of absorbing the first light and emitting second light having a different wavelength than the first light, wherein said fluorescent material comprises a phosphor having the formula (Lu_{1-x-y-a-b}YₓGd_{y})₃(Al_{1-z}Ga_{z})₅O₁₂:CeₐPr_{b} wherein 0 < x < 1, 0 < y < 1, 0 <z ≤ 0.1, 0 < a ≤ 0.2 and 0 < b ≤ 0.1; and
a second fluorescent material capable of emitting third light;
wherein the first fluorescent material and the second fluorescent material are disposed over the radiation source as discrete layers.

2. The system of claim 1 wherein the first light comprises light having a peak emission wavelength in the range of 400 to 480 nm.

3. The system of claim 1 wherein the first light comprises light having a peak emission wavelength in the range of 438 to 456 nm.

4. The system of claim 1 wherein the first light comprises light having a peak emission wavelength in the range of 330 to 365 nm.

5. The system of claim 1 wherein the radiation source is a light emitting diode.

6. The system of claim 1 wherein the second light is green light.

7. The system of claim 1 wherein the third light comprises red light.

8. The system of claim 1 wherein the second fluorescent material comprises an Eu(II)-activated phosphor.

9. The system of claim 1 wherein the second fluorescent material comprises (Sr_{1-x-y}BaₓCa_{y})_{2-z}Si₅₋ₐAlₐN₈₋ₐOₐ:Eu_{z} wherein 0 ≤ a < 5, 0 < x ≤ 1, 0 ≤ y ≤ 1, and 0 < z ≤ 1.

10. The system of claim 1 wherein the second fluorescent material comprises Sr₂Si₅N₈:Eu²⁺.

11. The system of claim 1 wherein the second fluorescent material comprises (Sr₁₋ₓCaₓ)S:Eu.

12. The system of claim 1 wherein the second fluorescent material is closer to the radiation source than the first fluorescent material.

13. The system of claim 1 further comprising a layer of transparent material disposed between the first fluorescent material and the second fluorescent material.

14. The system of claim 1 wherein:
the first fluorescent material is disposed over a first portion of the radiation source; and
the second fluorescent material is disposed over a second portion of the radiation source.

15. The system of claim 1 wherein:
the first fluorescent material is disposed over the radiation source in a plurality of first discrete regions; and
the second fluorescent material is disposed over the radiation source in a plurality of second discrete regions.

16. The system of claim 15 wherein the plurality of first discrete regions and the plurality of second discrete regions form a pattern.

17. The system of claim 15 further comprising a transparent material disposed over the radiation source in a plurality of third discrete regions.

18. The system of claim 1 wherein:
the second fluorescent material is disposed over the radiation source in a plurality of first discrete regions; and
the first fluorescent material is disposed over the second fluorescent material.

19. The system of claim 1 further comprising a third fluorescent material capable of emitting fourth light.

20. The system of claim 19 wherein the fourth light comprises blue light.

21. The system of claim 1 wherein particles of the first fluorescent material are coated with a layer of one or more compounds selected from the group formed by the fluorides and orthophosphates of the elements aluminum, scandium, yttrium, lanthanum gadolinium and lutetium, the oxides of aluminum, yttrium and lanthanum and the nitride of aluminum.

## Patentansprüche

1. System, umfassend:
eine Strahlungsquelle, die in der Lage ist, ein erstes Licht zu emittieren;
ein erstes fluoreszentes Material, das in der Lage ist, das erste Licht zu absorbieren und ein zweites Licht mit einer verschiedenen Wellenlänge als das erste Licht zu emittieren, wobei das fluoreszente Material ein Phosphor der Formel (Lu_{1-x-y-a-b}YₓGd_{y})₃(Al₁₋₂Ga_{z})₅O₁₂:CeₐPr_{b}, wobei 0 < x < 1, 0 < y < 1, 0 < z ≤ 0,1, 0 < a ≤ 0,2 und 0 < b ≤ 0,1 ist; und
ein zweites fluoreszentes Material, das in der Lage ist, ein drittes Licht zu emittieren;
wobei das erste fluoreszente Material und das zweite fluoreszente Material über der Strahlungsquelle als diskrete Schichten angeordnet sind.

2. System nach Anspruch 1, wobei das erste Licht ein Licht umfasst, das eine Spitzenemissions-Wellenlänge im Bereich von 400 bis 480 nm aufweist.

3. System nach Anspruch 1, wobei das erste Licht ein Licht umfasst, das eine Spitzenemissions-Wellenlänge im Bereich von 438 bis 456 nm aufweist.

4. System nach Anspruch 1, wobei das erste Licht ein Licht umfasst, das eine Spitzenemissions-Wellenlänge im Bereich von 330 bis 365 nm aufweist.

5. System nach Anspruch 1, wobei die Strahlungsquelle eine lichtemittierende Diode ist.

6. System nach Anspruch 1, wobei das zweite Licht ein grünes Licht ist.

7. System nach Anspruch 1, wobei das dritte Licht ein rotes Licht umfasst.

8. System nach Anspruch 1, wobei das zweite fluoreszente Material ein Eu(II)-aktiviertes Phosphor umfasst.

9. System nach Anspruch 1, wobei das zweite fluoreszente Material (Sr_{1-x-y}BaₓCa_{y})_{2-z}Si₅₋ₐAlₐN₈₋ₐOₐ:Eu_{z} aufweist, wobei 0 ≤ a < 5, 0 < x ≤ 1, 0 ≤ y ≤ y und 0 < z ≤ 1 ist.

10. System nach Anspruch 1, wobei das zweite fluoreszente Material Sr₂Si₅N₈:Eu²⁺ umfasst.

11. System nach Anspruch 1, wobei das zweite fluoreszente Material (Sr₁₋ₓCaₓ)S:Eu umfasst.

12. System nach Anspruch 1, wobei das zweite fluoreszente Material sich näher an der Strahlungsquelle befindet, als das erste fluoreszente Material.

13. System nach Anspruch 1, ferner umfassend eine Schicht aus transparentem Material, das zwischen dem ersten fluoreszenten Material und dem zweiten fluoreszenten Material angeordnet ist.

14. System nach Anspruch 1, wobei:
das erste fluoreszente Material über einem ersten Abschnitt der Strahlungsquelle angeordnet ist; und das zweite fluoreszente Material über einem zweiten Abschnitt der Strahlungsquelle angeordnet ist.

15. System nach Anspruch 1, wobei:
das erste fluoreszente Material über der Strahlungsquelle in einer Vielzahl von ersten diskreten Bereichen angeordnet ist; und
das zweite fluoreszente Material über der Strahlungsquelle in einer Vielzahl von zweiten diskreten Bereichen angeordnet ist.

16. System nach Anspruch 15, wobei die Vielzahl von ersten diskreten Bereichen und die Vielzahl von zweiten diskreten Bereichen ein Muster bilden.

17. System nach Anspruch 15, ferner umfassend ein transparentes Material, das über der Strahlungsquelle in einer Vielzahl von dritten diskreten Bereichen angeordnet ist.

18. System nach Anspruch 1, wobei:
das zweite fluoreszente Material über der Strahlungsquelle in einer Vielzahl von zweiten diskreten Bereichen angeordnet ist; und
das erste fluoreszente Material über dem zweiten fluoreszenten Material angeordnet ist.

19. System nach Anspruch 1, ferner umfassend ein drittes fluoreszentes Material, das in der Lage ist, ein viertes Licht zu emittieren.

20. System nach Anspruch 19, wobei das vierte Licht ein blaues Licht umfasst.

21. System nach Anspruch 1, wobei die Partikel des ersten fluoreszenten Materials mit einer Schicht aus einer oder mehreren Verbindungen beschichtet ist, die ausgewählt sind aus der Gruppe bestehend aus den Fluoriden und Orthophosphaten der Elemente Aluminium, Scandium, Yttrium, Lanthan, Gadolinium und Lutetium, den Oxiden von Aluminium, Yttrium und Lanthan sowie den Nitriden von Aluminium.

## Revendications

1. Système qui comprend :
une source de rayonnement capable d'émettre une première lumière ;
un premier matériau fluorescent capable d'absorber la première lumière et d'émettre une seconde lumière qui possède une longueur d'onde différente de la première lumière, ledit matériau fluorescent comprenant un phosphore qui possède la formule (Lu_{1-x-y-a-b}Yₓ(Gd_{y})₃(Al_{1-z}Ga_{z})₅O₁₂:CeₐPr_{b}, où 0 < x < 1, 0 < y < 1, 0 < z ≤ 0.1, 0 < a ≤ 0.2 et 0 < b ≤ 0.1 ; et
un second matériau fluorescent capable d'émettre une troisième lumière ;
dans lequel le premier matériau fluorescent et le second matériau fluorescent sont disposés par-dessus la source de rayonnement sous forme de couches discrètes.

2. Système selon la revendication 1, dans lequel la première lumière comprend une lumière qui possède une longueur d'onde d'émission maximale de l'ordre de 400 à 480 nm.

3. Système selon la revendication 1, dans lequel la première lumière comprend une lumière qui possède une longueur d'onde d'émission maximale de l'ordre de 438 à 456 nm.

4. Système selon la revendication 1, dans lequel la première lumière comprend une lumière qui possède une longueur d'onde d'émission maximale de l'ordre de 330 à 365 nm.

5. Système selon la revendication 1, dans lequel la source de rayonnement est une diode électroluminescente.

6. Système selon la revendication 1, dans lequel la seconde lumière est une lumière verte.

7. Système selon la revendication 1, dans lequel la troisième lumière comprend une lumière rouge.

8. Système selon la revendication 1, dans lequel le second matériau fluorescent comprend un phosphore activé par Eu(II).

9. Système selon la revendication 1, dans lequel le second matériau fluorescent comprend du (Sr_{1-x-y}BaₓCa_{y})_{2-z}Si₅₋ₐAlₐN₈₋ₐOₐ:Eu_{z}, où 0 ≤ a < 5, 0 < x ≤ 1, 0 ≤ y ≤ 1, et 0 z ≤ 1.

10. Système selon la revendication 1, dans lequel le second matériau fluorescent comprend du Sr₂Si₅N₈:Eu²⁺.

11. Système selon la revendication 1, dans lequel le second matériau fluorescent comprend du (Sr₁₋ₓCaₓ)S:Eu.

12. Système selon la revendication 1, dans lequel le second matériau fluorescent est plus proche de la source de rayonnement que le premier matériau fluorescent.

13. Système selon la revendication 1, qui comprend en outre une couche de matériau transparent disposée entre le premier matériau fluorescent et le second matériau fluorescent.

14. Système selon la revendication 1, dans lequel :
le premier matériau fluorescent est disposé par-dessus une première partie de la source de rayonnement ; et
le second matériau fluorescent est disposé par-dessus une seconde partie de la source de rayonnement.

15. Système selon la revendication 1, dans lequel :
le premier matériau fluorescent est disposé par-dessus la source de rayonnement dans une pluralité de premières zones discrètes ; et
le second matériau fluorescent est disposé par-dessus la source de rayonnement dans une pluralité de secondes zones discrètes.

16. Système selon la revendication 15, dans lequel la pluralité de premières zones discrètes et la pluralité de secondes zones discrètes forment un motif.

17. Système selon la revendication 15, qui comprend en outre un matériau transparent disposé par-dessus la source de rayonnement dans une pluralité de troisièmes zones discrètes.

18. Système selon la revendication 1, dans lequel :
le second matériau fluorescent est disposé par-dessus la source de rayonnement dans une pluralité de premières zones discrètes ; et
le premier matériau fluorescent est disposé par-dessus le second matériau fluorescent.

19. Système selon la revendication 1, qui comprend en outre un troisième matériau fluorescent capable d'émettre une quatrième lumière.

20. Système selon la revendication 19, dans lequel la quatrième lumière comprend une lumière bleue.

21. Système selon la revendication 1, dans lequel des particules du premier matériau fluorescent sont recouvertes d'une couche d'un ou plusieurs composé(s) choisi(s) parmi le groupe formé par les fluorures et les orthophosphates des éléments aluminium, scandium, yttrium, lanthane, gadolinium, et lutétium, les oxydes d'aluminium, d'yttrium et de lanthane, et le nitrure d'aluminium.
